# EUROPEAN PATENT SPECIFICATION

(11) **EP 0 413 962 B1**
(45) Date of publication and mention of the grant of the patent: **27.12.1996**
(21) Application number: 90113742.2
(22) Date of filing: 18.07.1990
(51) Int. Cl.: G21K 4/00, G01N 27/447

(54) **Imaging screen for electrophoresis applications and apparatus for the visualisation of the image**
Bilderzeugender Schirm für die Elektrophorese und Vorrichtung zur Bildwiedergabe
Ecran d'image pour les applications électrophorétiques et dispositif de visualisation d'image

(30) Priority: 24.07.1989 US 383534
(43) Date of publication of application: 27.02.1991
(73) Proprietor: QUANTEX CORPORATION, Rockville Maryland (US)
(72) Inventor: Lindmayer, Joseph, Potomac, Maryland (US); Wrigley, Charles Y., Ijamsville, Maryland (US); Storti, George M., Washington, D.C. (US)
(74) Representative: Di Iorio, Giuseppe, Dr.-Ing.

(56) References cited:
- EP-A- 0 126 218
- EP-A- 0 159 523
- US-A- 4 839 092

## Description

### IMAGING SCREEN FOR ELECTROPHORESIS APPLICATIONS

The assignee of the instant application is also the assignee of the following related United States patents and patent applications: U.S. Pat. No. 4,822,520, entitled PHOTOLUMINESCENT MATERIALS FOR OUTPUTTING BLUE-GREEN LIGHT; U.S. Pat. No. 4,839,092, entitled PHOTOLUMINESCENT MATERIALS FOR OUTPUTTING ORANGE LIGHT AND A PROCESS FOR MAKING SAME; U.S. Pat. No. 4,812,660, entitled PHOTOLUMINESCENT MATERIALS FOR OUTPUTTING YELLOW-GREEN LIGHT; U.S. Pat. No. 4,842,960, entitled HIGH EFFICIENCY PHOTOLUMINESCENT MATERIAL FOR OPTICAL UPCONVERSION; Patent No. 4,855,603, entitled PHOTOLUMINESCENT MATERIALS FOR RADIOGRAPHY; and Patent No. 4,879,186, entitled PHOTOLUMINESCENT MATERIALS FOR OUTPUTTING REDDISH-ORANGE LIGHT AND A PROCESS FOR MAKING THE SAME.

The disclosure of each of those related patent applications is incorporated by reference herein.

### BACKGROUND OF THE INVENTION

### 1. Field of the Invention:

The present invention relates generally to an imaging screen for electrophoresis applications and, more particularly, to an imaging screen for detecting and recording the impingement of beta particles or visible light emitted from electrophoresis gels.

### 2. Description of the Related Art:

In order to sequence deoxyribonucleic acid (DNA), it is necessary to chemically treat and label DNA fragments prior to performing electrophoresis. Specifically terminated fragments of the DNA are placed in wells in a gel and an electric field applied, resulting in the motion along well-defined lanes in the gel. Depending on the length of the fragments and the time for performing the electrophoresis, they will travel more or less far along the lanes. The result of the electrophoresis operation is a pattern of bands of DNA fragments.

If the fragments have been labelled with a beta particle emitter, it is possible to obtain a two-dimensional map of the pattern by placing X-ray film in relatively intimate contact to the gel. The X-ray film is somewhat sensitive to the beta particle radiation, and generally after long exposure will record the pattern. Unfortunately, such a procedure typically requires a time period on the order of days for the film to register a sufficient number of emitted, beta particles to provide an accurate representation of the pattern of bands.

Another drawback to this method is associated with the properties of X-ray film. Because of its limited dynamic range, and the complexity of obtaining quantitative information using such film, efforts have been undertaken to develop simpler, speedier and more accurate methodologies to detect radioactively labelled DNA fragments in electrophoresis gels.

Four beta emitters are-typically employed for tagging DNA fragments - i.e., ³²P, ³⁵S, ¹⁴C, and ³H. The beta particles end point energies are 1.71 MeV, 168 keV, 156 keV, and 18.6 keV, respectively. The electron ranges vary greatly, with ³²P having the longest range, and ³H having the shortest range.

Recently developed devices for obtaining quantitative information from radioactively labelled DNA, RNA or protein fragments in electrophoresis gels generally utilize two coincident grids which sense the beta emissions from the gels. Such a device is marketed as the Betascope 603 Blot Analyzer. That device can perform an analysis of the emitted beta particles in a number of hours. However, the Betascope device, and similar such devices, cannot readily detect the shorter range and lower energy beta particles. In addition, its spatial resolution is poor.

Fuji has developed a BaFBr imaging screen system which can work with ³²P, ³⁵S, and ¹⁴C, but is at least 1-2 orders of magnitude slower then the Betascope Blot Analyzer in processing the information contained in the radioactively labelled DNA, RNA or protein carrying electrophoresis gel.

An apparatus with the features included in the first part of claim 1 and, similarly, a method with the features included in the first part of claim 4 are known from EP-A-0 126 218. A variety of substances are disclosed in this document as an electron trapping material for use in the apparatus and method; while strontium sulphide doped with samarium and cerium is among these substances, europium activated alkaline earth metal fluorohalide stimulable phosphors are preferred.

### SUMMARY OF THE INVENTION

It is an object of the invention to provide a simple, speedy and accurate methodology for detecting radioactive traces emitted from electrophoresis gels with superior sensitivity. Preferably, such methodology should be suited to detect dye-tagged and chemiluninescent traces which emit visible light, which the Fuji BaFbr system cannot detect.

This object is met by the apparatus defined in claims 1, 6, 7 and 10, the method defined in claims 4, 8, 9 and 15, and the imaging screen defined in claim 14, respectively.

### BRIEF DESCRIPTION OF THE DRAWING

Fig. 1 is an overall block diagram of the system in which the imaging screen is scanned in a pixel-by-pixel manner and the light output from the screen is detected by a photomultiplier;
Fig. 2 is an overall block diagram of the system in which the light detector is a CID camera and the entire surface of the imaging screen is illuminated with infrared light for readout;
Fig. 3 is a schematic illustrating the principle of operation of the electron trapping material of the present invention; and
Fig. 4 shows a cross-section of the imaging screen of the present invention.

### DETAILED DESCRIPTION OF THE PREFERRED EMBODIMENT

Referring now in detail to the drawing, there is illustrated in a detection system 10 for use with an imaging screen 12, fabricated as will be described later herein. Screen 12 has been placed on an electrophoresis gel containing radioactively labelled, dye-tagged, or chemiluminescent labelled DNA, RNA or other protein fragments for exposure. The beta particles or visible light emitted by the labelled or tagged fragments impinge upon the surface of the imaging screen which is coated with an electron trapping material as described later. A laser 14 is utilized to scan the surface of the imaging screen by impinging a laser beam onto the electron trapping material in a row-by-row and column-by-column manner. The imaging screen in mounted on an x-y stepping stage 16 for that purpose.

Laser 14 is preferably a 50 milliwatt Nd:Yag laser with an output having a wavelength centered about 1064 nm. Alternatively, a laser diode, with an output centered about 860 nm may be used in the present invention. In the operation of the device, laser 14 reads out the information stored in the electron trapping material. When it is desired to "erase" the impingement pattern stored in the electron trapping material, broad area infrared light produced by a filtered light source can be employed for the erasure. The output of laser 14 is controlled by a constant current power supply (not shown). The output from laser 14 is collimated by collimating optics 18 and then reflected by a IR mirror 22 through a cold mirror 24 and into a 20x microscope objective 20. A micrometer 26 is used to adjust the image of the laser beam down to less than a 20 micron spot on imaging screen 12.

As mentioned previously, imaging screen 12 is mounted on a x-y stepping stage 16, such as that available from Aerotech, for serial scan-readout. An x-y translator controller 28, under command of a microcomputer 30, moves the x-y stepping stage 16 so that the trapped electron population is scanned by laser 14 in a pixel-by-pixel manner. The release of trapped electrons in the electron trapping material results in the emission of visible light, which travels back up through microscope objective 20 and is deflected by cold mirror 24 through a short pass filter 31 and into a visible light detector 32, preferably a photomultiplier tube such as Hamamatsu Model R268.

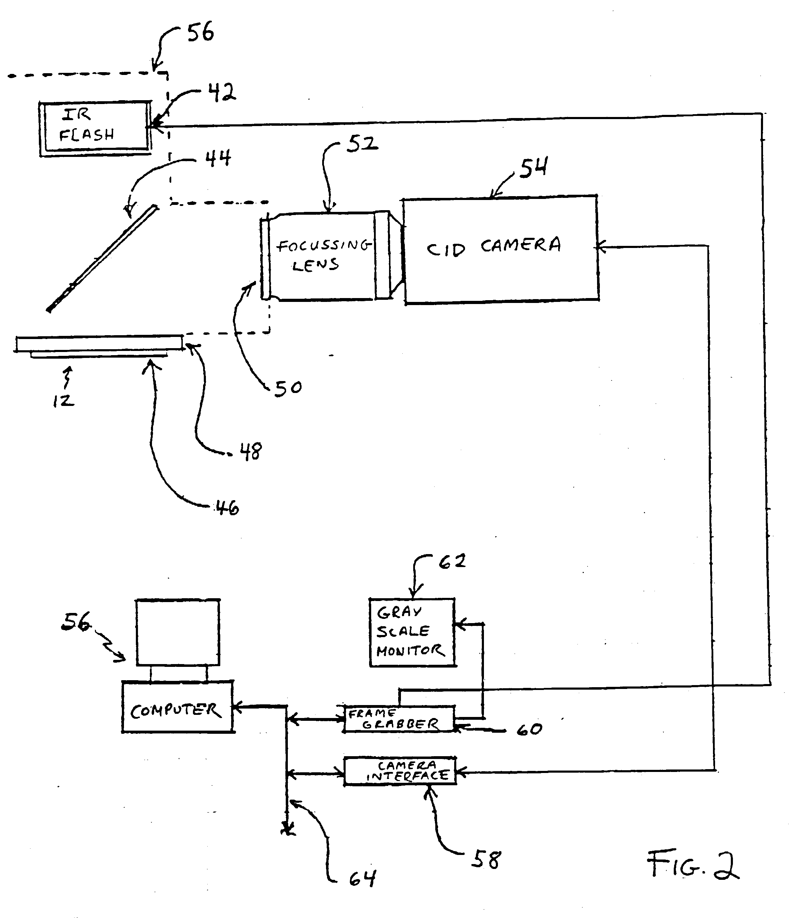

Alternatively, visible light detector 32 can be a solid state image capture array, such as a CID or CCD, e.g., a Fairchild CID 2250 camera chip. In this case, as shown in Fig. 2, the entire surface of imaging screen 12 is illuminated with infrared light for read out; i.e. scanning is not necessary.

In the preferred arrangement shown in Fig. 2, infrared illumination is provided by an infrared flash 42. The infrared light passes through a cold mirror 44 and onto the imaging screen 12. Imaging screen 12 may be mounted in the film holder 46 of a camera back 48. The visible light emitted from the electron trapping material is reflected off cold mirror 44 and passes through an optical filter 50 and a lens 52 before entering a CID camera 54. Optical filter 50 is of the type that transmits visible light and blocks infrared light. Lens 52 is a 55mm f2.8 lens which focuses an image of imaging screen 12 onto CID camera 54. A light-tight enclosure 56 prevents external light from entering the optical portion of the system.

The system of Fig. 2 is controlled by a microcomputer 56. Specifically, microcomputer 56 controls CID camera 54 via a camera interface 58. Each frame of video information corresponding to the image received by CID camera 54 is collected by a frame grabber 60 (under control of microcomputer 56) and displayed on a gray scale video monitor 62. Frame grabber 60 also generates a signal for triggering infrared flash 42. Digital communication between microcomputer 56, camera interface 58 and frame grabber 62 occurs over a computer bus 64.

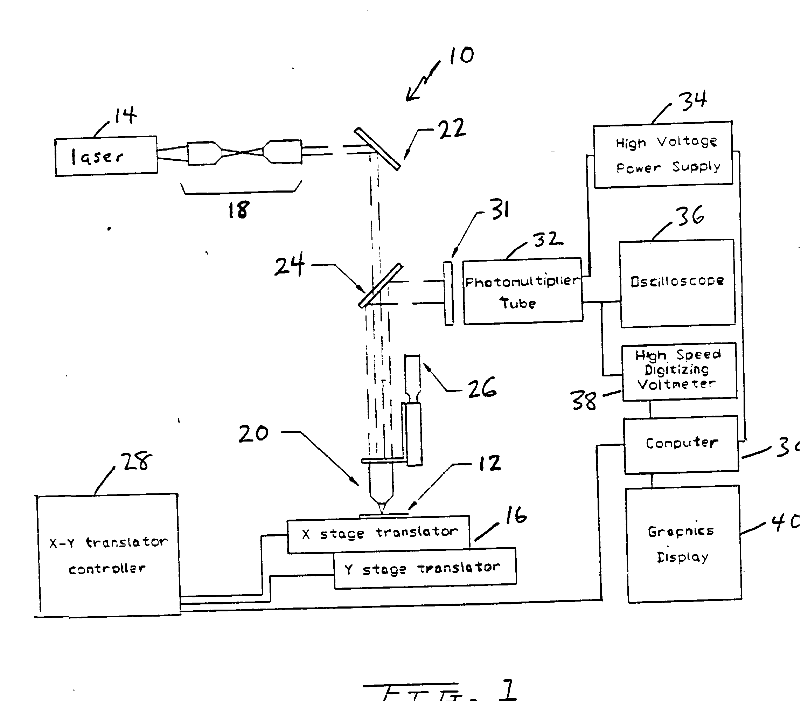

If a photomultiplier is used the visible light detector as shown in Fig. 1, it is powered by a high voltage power supply 34, and the output of the photomultiplier (an electrical signal proportional to the detected visible light input) is fed to an oscilloscope 36 (for visual display) and to a high speed digitizing voltmeter 38 (for A/D conversion). The digital output of digitizing voltmeter 38 is fed into microcomputer 30 for processing and conversion into an image which is displayed on graphics display 40.

As will be apparent to those skilled in the art, the above-described system and its components are merely the preferred embodiment of the invention. Thus, many other types of infrared light sources, scanning systems and visible light detectors may be utilized to stimulate the charged electron trapping material in imaging screen 12 and to detect the visible light emitted therefrom. The preferred embodiment described above is capable of resolving a "pixel" size of 200 micrometers or smaller on the surface of imaging screen 12.

The electron trapping material and the fabrication of imaging screen 12 will now be described.

The electron trapping material utilized in the present invention is a novel photoluminescent material which can be "charged" by the radiation or visible light to be measured; upon such energetic exposure, electrons in the material are raised to a higher energy state where they are "trapped" and stay indefinitely. When low energy photons (such as infrared) impinge upon the material, the stored electrons are released from their traps, and, upon falling to a lower energy level, emit visible light which can be detected and measured.

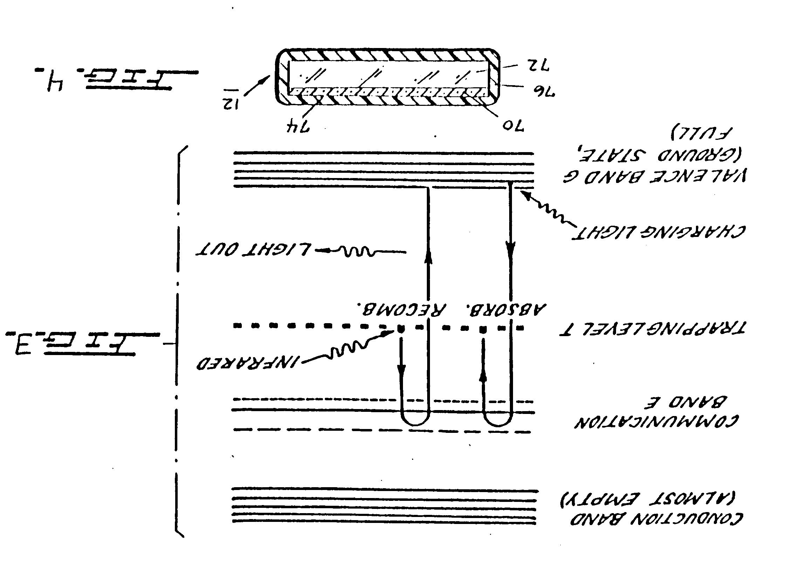

Fig. 3 shows the principles of operation of the electron trapping material used in the present invention. The basic crystalline photoluminescent material used has a valence band G full of electrons at a ground state. The material is subjected to radiation or visible light which functions to energize certain electrons in the valence band G. An electron shown on the left is originally in a valence band G and is subjected to charging radiation or visible light. The electron absorbs a beta particle or photon raising its energy level to a communication band E where communication takes place with other energized electrons resulting in transitions. Upon removal of the energizing radiation or light, the electron may drop back to a trapping level T or back to the valence band G depending upon the composition of the material and available trapping sites. The electron, if in the trapping level T, will remain isolated from other electrons and trapped until sufficient additional energy is provided to the electron to raise its energy back up to the communication band E where it may interact with other electrons and undergo recombination causing it to move back to the valence band G and output a photon of visible light in the process.

The number of trapping sites, the depth of the traps and the probability of transitions occuring in the communication band are all dependent upon the composition of the photoluminescent material used.

The electron trapping material is formed of a strontium sulfide and/or calcium sulfide base combined with samarium metal or a samarium compound as a first dopant and either a europium compound or a cerium compound, or both, as a second dopant. Lithium fluoride is preferably added as a flux to provide fusibility, and barium sulfate can be used to improve the brightness of light output from the material.

In the case of analyzing a radioactively labelled biological fragments, a cerium compound is used as a second dopant to provide an electron trapping material with improved sensitivity to beta particles. Examples of such electron trapping materials are disclosed in U.S. Patent No. 4,822,520, U.S. Patent No. 4,855,603, and U.S. Patent No. 4,812,660, the disclosures of which are herein incorporated by reference. The electron trapping materials of the first two patents emit blue-green light, while the material of the third patent emits a yellow-green light.

In the case of analyzing a dye-tagged or chemiluminescent labelled electrophoresis gel, it is preferable to use a europium compound as the second dopant to provide an electron trapping material with a brighter output. Examples of europium doped electron trapping materials are disclosed in U.S. Patent No. 4,839,092, U.S. Patent No. 4,842,960 and U.S. Patent No. 4,879,186, the disclosures of which are herein incorporated by reference. The electron trapping materials of the first two patents emit orange light, while the material of the third patent emits a reddish-orange light.

The cerium and europium doped electron trapping materials described in the above-identified patents have electron traps on the order of approximately 1.0 eV.

The process for making thick and thin film versions of the various cerium and europium doped electron trapping material is described in detail in the referenced patents and is not repeated here. Either a thick or thin film of the electron trapping material may be applied to a substrate (e.g. vitreous quartz) to form the detector screen of the present invention. The advantage of the thick film version (having a thickness on the order of hundreds of microns) is that all incoming flux, e.g. beta particles, is absorbed by the material and stored as energy in the form of trapped electrons. The advantage of the thin film version (having a thickness on the order of microns) is that very low energy beta particles such as from ³H can be detected with a higher signal to noise ratio.

If higher energy radioactive particles are to be detected (e.g. from ³²P, ³⁵S, or ¹⁴C), the electron trapping material is fused at a high temperature, ground, either attached or reheated at a lower temperature and then mixed with a binder and dispersed onto the substrate.

The thin film version can be used where the flux emitted from the electrophoresis gel is of very low energy. Generally, the thin film version is prepared by physical vapor deposition of the fused material directly onto the substrate. The patents referenced above provide a more detailed discussion of the thick and thin film deposition techniques.

Fig. 4 shows a cross-sectional view of an imaging screen 12 in which a film of electron trapping material 70 is disposed upon a substrate 72. Any of a number of known materials having suitable properties may be used for the substrate 72. Some examples of substrates that may be useful are: sapphire, alumina, other ceramics, quartz, fiber optic faceplates, other glasses, metals such as aluminum, various organic polymers, and polycarbonates. The material 70 establishes a planar surface 74 on substrate 72. An optional transparent coating 76 may encapsulate the material 70 and substrate 72.

Although the present invention has been described in relation to particular embodiments thereof, many other variations and modifications and other uses will become apparent to those skilled in the art. It is preferred, therefore, that the present invention be limited not by the specific disclosure herein but only by the appended claims.

## Claims

1. An apparatus for obtaining information from an electrophoresis gel containing a sample of radioactively labelled DNA, RNA or protein, comprising
means for detecting and storing information corresponding to the impingement of a pattern of emission from said electrophoresis gel, comprising an imaging screen coated with an electron trapping material for releasably storing said information as energy corresponding to the flux and pattern of said emission,
means for applying optical energy of a first wavelength to said electron trapping material for causing said electron trapping material to release optical energy of a second wavelength corresponding to said flux and pattern of said emission, and
means for sensing said released optical energy of said second wavelength and for converting said released optical energy to electrical signals representative of said flux and pattern of said emission,
**characterised** in that said electron trapping material comprises
a base material comprising substantially strontium sulfide,
a first dopant of samarium provided in a quantity of between 70 to 300 parts per million by weight, and
a second dopant of cerium oxide provided in a quantity of between 600 to 1500 parts per million by weight.

2. The apparatus of claim 1, wherein said pattern of emission on said detector is accumulated over a period of time, effectively integrating the resulting stored pattern.

3. The apparatus of claim 1, wherein said emission comprises beta particles released from radioactively labelled DNA, RNA or protein in said electrophoresis gel.

4. A method for obtaining data from an electrophoresis gel containing a sample of radioactively labelled DNA, RNA or protein, comprising the steps of
placing said electrophoresis gel on an imaging screen coated with an electron trapping material for detecting and storing energy corresponding to flux and pattern of the emission from said electrophoresis gel,
subjecting said electron trapping material to optical energy of a first wavelength to cause said electron trapping material to release optical energy of a second wavelength corresponding to said flux and pattern of said emission, and
sensing said released optical energy of a second wavelength and converting said optical energy to electrical signals representative of said flux and pattern of said emission,
**characterised** in that said electron trapping material comprises
a base material comprising substantially strontium sulfide,
a first dopant of samarium provided in a quantity of between 70 to 300 parts per million by weight, and
a second dopant of cerium oxide provided in a quantity of between 600 to 1500 parts per million by weight.

5. The method of claim 4, wherein the depth of traps contained in said electron trapping material is about 1.0 eV.

6. An apparatus for obtaining information from an electrophoresis gel containing a sample of radioactively labelled DNA, RNA or protein, comprising
means for detecting and storing information corresponding to the impingement of a pattern of emission from said electrophoresis gel, comprising an imaging screen coated with an electron trapping material for releasably storing said information as energy corresponding to the flux and pattern of said emission,
means for applying optical energy of a first wavelength to said electron trapping material for causing said electron trapping material to release optical energy of a second wavelength corresponding to said flux and pattern of said emission, and
means for sensing said released optical energy of said second wavelength and for converting said released optical energy to electrical signals representative of said flux and pattern of said emission,
**characterised** in that said electron trapping material comprises
a base material selected from the group of alkaline earth metal sulfides,
a first dopant of samarium,
a second dopant selected from the group of cerium oxide, cerium fluoride, cerium chloride, and cerium sulfide, and
a cesium halide.

7. An apparatus for obtaining information from an electrophoresis gel containing a sample of radioactively labelled DNA, RNA or protein, comprising
means for detecting and storing information corresponding to the impingement of a pattern of emission from said electrophoresis gel, comprising an imaging screen coated with an electron trapping material for releasably storing said information as energy corresponding to the flux and pattern of said emission,
means for applying optical energy of a first wavelength to said electron trapping material for causing said electron trapping material to release optical energy of a second wavelength corresponding to said flux and pattern of said emission, and
means for sensing said released optical energy of said second wavelength and for converting said released optical energy to electrical signals representative of said flux and pattern of said emission,
**characterised** in that said electron trapping material has a peak infrared sensitivity within the range of 1.12 or 1.22 µm and emitting in response to infrared radiation an output of yellow-green light and comprises
a base material comprising substantially calcium sulfide,
a first dopant of samarium provided in a quantity between 50 and 300 parts per million by weight, and
a second dopant selected from the group of cerium oxide, cerium fluoride, cerium chloride, and cerium sulfide provided in a quantity between 200 and 1500 parts per million by weight.

8. A method for obtaining data from an electrophoresis gel containing a sample of radioactively labelled DNA, RNA or protein, comprising the steps of
placing said electrophoresis gel on an imaging screen coated with an electron trapping material for detecting and storing energy corresponding to flux and pattern of the emission from said electrophoresis gel,
subjecting said electron trapping material to optical energy of a first wavelength to cause said electron trapping material to release optical energy of a second wavelength corresponding to said flux and pattern of said emission, and
sensing said released optical energy of a second wavelength and converting said optical energy to electrical signals representative of said flux and pattern of said emission,
**characterised** in that said electron trapping material comprises
a base material selected from the group of alkaline earth metal sulfides,
a first dopant of samarium,
a second dopant selected from the group of cerium oxide, cerium fluoride, cerium chloride, and cerium sulfide, and
a cesium halide.

9. A method for obtaining data from an electrophoresis gel containing a sample of radioactively labelled DNA, RNA or protein, comprising the steps of
placing said electrophoresis gel on an imaging screen coated with an electron trapping material for detecting and storing energy corresponding to flux and pattern of the emission from said electrophoresis gel,
subjecting said electron trapping material to optical energy of a first wavelength to cause said electron trapping material to release optical energy of a second wavelength corresponding to said flux and pattern of said emission, and
sensing said released optical energy of a second wavelength and converting said optical energy to electrical signals representative of said flux and pattern of said emission,
**characterised** in that said electron trapping material has a peak infrared sensitivity within the range of 1.12 or 1.22 µm and emitting in response to infrared radiation an output of yellow-green light and comprises
a base material comprising substantially calcium sulfide,
a first dopant of samarium provided in a quantity between 50 and 300 parts per million by weight, and
a second dopant selected from the group of cerium oxide, cerium fluoride, cerium chloride, and cerium sulfide provided in a quantity between 200 and 1500 parts per million by weight.

10. An apparatus for obtaining information from an electrophoresis gel containing a sample of dye-tagged or chemiluminescent labelled DNA, RNA or protein, comprising
means for detecting and storing information corresponding to the impingement of a pattern of visible light emission from said electrophoresis gel, comprising an imaging screen coated with an electron trapping material for releasably storing said information as energy corresponding to the flux and pattern of said visible light emission,
means for applying optical energy of a first wavelength to said electron trapping material for causing said electron trapping material to release optical energy of a second wavelength corresponding to said flux and pattern of said visible light emission, and
means for sensing said released optical energy of said second wavelength and for converting said released optical energy to electrical signals representative of said flux and pattern of said visible light emission.

11. The apparatus of claim 10, wherein said electron trapping material comprises a base material of an alkaline earth metal sulfide or a mixture of alkaline earth metal sulfides doped with samarium metal or a samarium compound and doped with a europium compound.

12. The apparatus of claim 11, wherein said electron trapping material further comprises a fusible salt.

13. The apparatus of claim 1 or 10, further including means for applying erase optical energy to said means for detecting and storing information for erasing the information stored thereon.

14. An erasable imaging screen for use with electrophoresis gels containing a sample of dye-tagged or chemiluminescent labelled DNA, RNA or protein, comprising
a substrate carrying an electron trapping material for detecting and storing the pattern of visible light emission from said electrophoresis gel, said electron trapping material being capable of releasing optical energy of a first wavelength corresponding to the stored pattern of visible light emission when subjected to optical energy of a second wavelength.

15. A method for obtaining data from an electrophoresis gel containing a sample of dye-tagged or chemiluminescent labelled DNA, RNA or protein, comprising the steps of
placing said electrophoresis gel on an imaging screen coated with an electron trapping material for detecting and storing energy corresponding to flux and pattern of the visible light emission from said electrophoresis gel,
subjecting said electron trapping material to optical energy of a first wavelength to cause said electron trapping material to release optical energy of a second wavelength corresponding to said flux and pattern of said visible light emission, and
sensing said released optical energy of a second wavelength and converting said optical energy to electrical signals representative of said flux and pattern of said visible light emission.

16. The method of claim 4 or 15, further including the step of applying erase optical energy to said electron trapping material for erasing the radiation pattern stored thereon.

## Patentansprüche

1. Vorrichtung zum Gewinnen von Informationen von einem Elektrophorese-Gel, das eine Probe von radioaktiv markierter DNA, RNA oder Protein enthält, mit:
Einrichtungen zur Detektion und Speicherung von Information, die dem Auftreffen eines Musters von Emission von dem Elektrophorese-Gel entspricht, wobei die Einrichtungen einen Bilderzeugungsschirm umfassen, der mit einem Elektronen einfangenden Material beschichtet ist, um die Information in freigebbarer Weise als Energie entsprechend dem Fluß und dem Muster der Emission zu speichern,
Einrichtungen zum Zuführen von optischer Energie mit einer ersten Wellenlänge an das Elektronen einfangende Material, um zu bewirken, daß das Elektronen einfangende Material optische Energie mit einer zweiten Wellenlänge freigibt, die dem Fluß und dem Muster der Emission entspricht, und
Einrichtungen zur Messung der freigegebenen optischen Energie mit der zweiten Wellenlänge und zur Umwandlung der freigegebenen optischen Energie in elektrische Signale, die den Fluß und das Muster der Emission darstellen,
dadurch gekennzeichnet, daß das Elektronen einfangende Material
ein Basismaterial, das im wesentlichen aus Strontiumsulfid besteht,
ein erstes Dotierungsmittel aus Samarium, das in einer Menge von ungefähr 70 bis 300 Gewichtsteilen pro Million vorgesehen ist, und
ein zweites Dotierungsmittel aus Ceroxid umfaßt, das in einer Menge von zwischen 600 und 1500 Gewichtsteilen pro Million vorgesehen ist.

2. Vorrichtung nach Anspruch 1,
dadurch gekennzeichnet, daß das Muster der Emission an dem Detektor über eine Zeitperiode akkumuliert wird, wodurch das resultierende gespeicherte Muster effektiv integriert wird.

3. Vorrichtung nach Anspruch 1, bei dem die Emission Betateilchen umfaßt, die von radioaktiv markierter DNA, RNA oder von Protein in dem Elektrophorese-Gel freigegeben werden.

4. Verfahren zur Gewinnung von Daten von einem Elektrophorese-Gel, das eine Probe von radioaktiv markierter DNA, RNA oder von Protein enthält, mit den folgenden Schritten:
Anordnen des Elektrophorese-Gels auf einem Bilderzeugungsschirm, der mit einem Elektronen einfangenden Material beschichtet ist, um die dem Fluß und dem Muster der Emission von dem Elektrophorese-Gel entsprechende Energie zu detektieren und zu speichern,
Beaufschlagen des Elektronen einfangenden Materials mit optischer Energie einer ersten Wellenlänge, um zu bewirken, daß das Elektronen einfangende Material optische Energie mit einer zweiten Wellenlänge freigibt, die dem Fluß und dem Muster der Emission entspricht, und
Messen der freigegebenen optischen Energie mit einer zweiten Wellenlänge und Umwandeln der optischen Energie in elektrische Signale, die den Fluß und das Muster der Emission darstellen,
dadurch gekennzeichnet, daß das Elektronen einfangende Material
ein Basismaterial, das im wesentlichen aus Strontiumsulfid besteht,
ein erstes Dotierungsmittel aus Samarium, das in einer Menge von zwischen 70 bis 300 Gewichtsteilen pro Million vorliegt, und
ein zweites Dotierungsmittel aus Ceroxid umfaßt, das in einer Menge von zwischen 600 bis 1500 Gewichtsteilen pro Millionen vorliegt.

5. Verfahren nach Anspruch 4,
bei dem die Tiefe der in dem Elektronen einfangenden Material enthaltenen Einfangstellen ungefähr 1,0 eV beträgt.

6. Vorrichtung zum Gewinnen von Informationen von einem Elektrophorese-Gel, das eine Probe von radioaktiv markierter DNA, RNA oder von Protein enthält, mit:
Einrichtungen zum Detektieren und Speichern von Informationen, die dem Auftreffen eines Musters der Emission von dem Elektrophorese-Gel entspricht, wobei die Einrichtungen einen Bilderzeugungsschirm umfassen, der mit einem Elektronen einfangenden Material zum freigebbaren Speichern der Information als dem Fluß und dem Muster der Emission entsprechender Energie aufweisen,
Einrichtungen zum Zuführen optischer Energie mit einer ersten Wellenlänge an das Elektronen einfangende Material, um zu bewirken, daß das Elektronen einfangende Material optische Energie mit einer zweiten Wellenlänge freigibt, die dem Fluß und Muster der Emission entspricht, und
Einrichtungen zur Messung der freigegebenen optischen Energie mit der zweiten Wellenlänge und zur Umwandlung der freigegebenen optischen Energie in elektrische Signale, die den Fluß und das Muster der Emission darstellen,
dadurch gekennzeichnet, daß das Elektronen einfangende Material
ein Basismaterial, das aus der Gruppe von Erdalkalimetall-Sulfiden ausgewählt ist,
ein erstes Dotierungsmittel aus Samarium,
ein zweites Dotierungsmittel, das aus der Gruppe von ceroxid, Cerfluorid, Cerchlorid und Cersulfid ausgewählt ist, und
ein Cäsiumhalid umfaßt.

7. Vorrichtung zum Gewinnen von Informationen von einem Elektrophorese-Gel, das eine Probe von radioaktiv markierter DNA, RNA oder Protein enthält, mit:
Einrichtungen zur Detektion und Speicherung von Information die dem Auftreffen eines Musters von Emission von dem Elektrophorese-Gel entspricht, wobei die Einrichtungen einen Bilderzeugungsschirm umfassen, der mit einem Elektronen einfangenden Material beschichtet ist, um die Information in freigebbarer Weise als Energie entsprechend dem Fluß und dem Muster der Emission zu speichern,
Einrichtungen zum Zuführen von optischer Energie mit einer ersten Wellenlänge an das Elektronen einfangende Material, um zu bewirken, daß das Elektronen einfangende Material optische Energie mit einer zweiten Wellenlänge freigibt, die dem Fluß und dem Muster der Emission entspricht, und
Einrichtungen zur Messung der freigegebenen optischen Energie mit der zweiten Wellenlänge und zur Umwandlung der freigegebenen optischen Energie in elektrische Signale, die den Fluß und das Muster der Emission darstellen,
dadurch gekennzeichnet, daß das Elektronen einfangende Material eine Infrarot-Spitzenempfindlichkeit im Bereich von 1,12 oder 1,22 µm aufweist und als Antwort auf die InfrarotStrahlung ein Ausgangssignal in Form von gelb-grünem Licht emittiert, und
ein Basismaterial, das im wesentlichen aus Kalziumsulfid besteht,
ein erstes Dotierungsmittel aus Samarium, das in einer Menge zwischen 50 und 300 Gewichtsteilen pro Millionen vorliegt, und
ein zweites Dotierungsmittel umfaßt, das aus der Gruppe von Ceroxid, Cerfluorid, Cerchlorid und Cersulfid ausgewählt ist und in einer Menge von zwischen 200 und 1500 Gewichtsteilen pro Millionen vorliegt.

8. Verfahren zur Gewinnung von Daten von einem Elektrophorese-Gel, das eine Probe von radioaktiv markierter DNA, RNA oder von Protein enthält, mit den folgenden Schritten:
Anordnen des Elektrophorese-Gels auf einem Bilderzeugungsschirm, der mit einem Elektronen einfangenden Material beschichtet ist, um die dem Fluß und dem Muster der Emission von dem Elektrophorese-Gel entsprechende Energie zu detektieren und zu speichern,
Beaufschlagen des Elektronen einfangenden Materials mit optischer Energie einer ersten Wellenlänge, um zu bewirken, daß das Elektronen einfangende Material optische Energie mit einer zweiten Wellenlänge freigibt, die dem Fluß und dem Muster der Emission entspricht, und
Messen der freigegebenen optischen Energie mit einer zweiten Wellenlänge und Umwandeln der optischen Energie in elektrische Signale, die den Fluß und das Muster der Emission darstellen,
dadurch gekennzeichnet, daß das Elektronen einfangende Material
ein Basismaterial, das aus der Gruppe von Erdalkalimetall-Sulfiden ausgewählt ist,
ein erstes Dotierungsmittel aus Samarium,
ein zweites Dotierungsmittel, das aus der Gruppe von Ceroxid, Cerfluorid, Cerchlorid und Cersulfid ausgewählt ist, und
ein Cäsium-Halid umfaßt.

9. Verfahren zur Gewinnung von Daten von einem Elektrophorese-Gel, das eine Probe von radioaktiv markierter DNA, RNA oder von Protein enthält, mit den folgenden Schritten:
Anordnen des Elektrophorese-Gels auf einem Bilderzeugungsschirm, der mit einem Elektronen einfangenden Material beschichtet ist, um die dem Fluß und dem Muster der Emission von dem Elektrophorese-Gel entsprechende Energie zu detektieren und zu speichern,
Beaufschlagen des Elektronen einfangenden Materials mit optischer Energie einer ersten Wellenlänge, um zu bewirken, daß das Elektronen einfangende Material optische Energie mit einer zweiten Wellenlänge freigibt, die dem Fluß und dem Muster der Emission entspricht, und
Messen der freigegebenen optischen Energie mit einer zweiten Wellenlänge und Umwandeln der optischen Energie in elektrische Signale, die den Fluß und das Muster der Emission darstellen,
dadurch gekennzeichnet, daß das Elektronen einfangende Material
eine Infrarot-Spitzenempfindlichkeit in dem Bereich von 1,12 oder 1,22 µm aufweist und als Antwort auf die Infrarotstrahlung eine Ausgangssignal aus gelb-grünem Licht emittiert, und
ein Basismaterial, das im wesentlichen aus Kalziumsulfid besteht, ein erstes Dotierungsmittel als Samarium, das in einer Menge von zwischen 50 und 300 Gewichtsteilen pro Million vorliegt, und
ein zweites Dotierungsmittel umfaßt, das aus der Gruppe von Ceroxid, Cerfluorid, Cerchlorid und Cersulfid ausgewählt ist und in einer Menge von zwischen 200 und 1500 Gewichtsteilen pro Million vorliegt.

10. Vorrichtung zum Gewinnen von Informationen von einem Elektrophorese-Gel, das eine Probe von Farbstoff-markierter oder chemilumineszent markierter DNA, RNA oder Protein enthält, mit:
Einrichtungen zur Detektion und Speicherung von Information, die dem Auftreffen eines Musters von sichtbarer Lichtemission von dem Elektrophorese-Gel entspricht, wobei die Einrichtungen einen Bilderzeugungsschirm umfassen, der mit einem Elektronen einfangenden Material beschichtet ist, um die Information in freigebbarer Weise als Energie entsprechend dem Fluß und dem Muster der sichtbaren Lichtemission zu speichern,
Einrichtungen zum Zuführen von optischer Energie mit einer ersten Wellenlänge an das Elektronen einfangende Material, um zu bewirken, daß das Elektronen einfangende Material optische Energie mit einer zweiten Wellenlänge freigibt, die dem Fluß und dem Muster der Emission entspricht, und
Einrichtungen zur Messung der freigegebenen optischen Energie mit der zweiten Wellenlänge und zur Umwandlung der freigegebenen optischen Energie in elektrische Signale, die den Fluß und das Muster der sichtbaren Lichtemission darstellen.

11. Vorrichtung nach Anspruch 10, bei dem das Elektronen einfangende Material ein Basismaterial aus einem Erdalkalimetall-Sulfid oder einer Mischung von Erdalkalimetallsulfiden umfaßt, das mit Samarium-Metall oder einer Samariumverbindung dotiert ist, und mit einer Europium-Verbindung dotiert ist.

12. Vorrichtung nach Anspruch 11, bei dem das Elektronen einfangende Material weiterhin ein schmelzbares Salz umfaßt.

13. Vorrichtung nach Anspruch 1 oder 10, die weiterhin Einrichtungen zum Zuführen von optischer Löschenergie an die Einrichtungen zum Detektieren und Speichern einschließt, um die darin gespeicherte Information zu löschen.

14. Löschbarer Bilderzeugungsschirm zur Verwendung mit Elektophorese-Gelen, die eine Probe von Farbstoff-markierter oder chemielumineszent markierter DNA, RNA oder Protein enthalten, mit:
einem Substrat, das ein Elektronen einfangendes Material zur Detektion und zur Speicherung des Musters der sichtbaren Lichtemission von dem Elektrophorese-Gel trägt, wobei das Elektronen einfangende Material in der Lage ist, optische Energie mit einer ersten Wellenlänge entsprechend dem gespeicherten Muster der sichtbaren Lichtemission freizugeben, wenn es mit der optischen Energie einer zweiten Wellenlänge beaufschlagt wird.

15. Verfahren zum Gewinnen von Daten von einem Elektrophorese-Gel, das eine Probe von Farbstoff-markierten oder chemielumineszent markierter DNA, RNA oder von Protein enthält, mit den folgenden Schritten:
Aufbringen des Elektrophorese-Gels auf einen Bilderzeugungsschirm, der mit einem Elektronen einfangenden Material beschichtet ist, um dem Fluß und dem Muster der sichtbaren Lichtemission von dem Elektrophorese-Gel entsprechende Energie zu detektieren und zu speichern,
Beaufschlagen des Elektronen einfangenden Materials mit optischer Energie mit einer ersten Wellenlänge, um zu bewirken, daß das Elektronen einfangende Material optische Energie mit einer zweiten Wellenlänge entsprechend dem Fluß und dem Muster der sichtbaren Lichtemission freigibt, und
Messen der freigegebenen optischen Energie mit einer zweiten Wellenlänge zur Umwandlung der optischen Energie in elektrische Signale, die den Fluß und das Muster der sichtbaren Lichtemission darstellen.

16. Verfahren nach Anspruch 4 oder 15, das weiterhin den Schritt des Zuführens von optischer Löschenergie an das Elektronen einfangende Material einschließt, um das darin gespeicherte Strahlungsmuster zu löschen.

## Revendications

1. Appareil destiné à l'obtention d'informations d'un gel d'électrophorèse contenant un échantillon de DNA, de RNA ou de protéine marqué radioactivement, comprenant
un dispositif de détection et de mémorisation d'informations correspondant à l'incidence d'un diagramme d'émission du gel d'électrophorèse, comprenant un écran de formation d'image revêtu d'un matériau de piégeage d'électrons destiné à accumuler temporairement les informations sous forme d'énergie correspondant au flux et au diagramme d'émission,
un dispositif d'application d'énergie optique à une première longueur d'onde au matériau de piégeage d'électrons de manière que ce matériau libère de l'énergie optique à une seconde longueur d'onde correspondant au flux et au diagramme d'émission, et
un dispositif de détection de l'énergie optique libérée à la seconde longueur d'onde et de transformation de l'énergie optique libérée en signaux électriques représentatifs du flux et du diagramme d'émission,
caractérisé en ce que le matériau de piégeage d'électrons comprend
un matériau de base contenant essentiellement du sulfure de strontium,
une première matière de dopage de samarium présente en quantité comprise entre 70 et 300 parties par million en poids, et
une seconde matière de dopage d'oxyde de cérium présente en quantité comprise entre 600 et 1 500 parties par million en poids.

2. Appareil selon la revendication 1, dans lequel le diagramme d'émission sur le détecteur est accumulé sur une certaine période, par intégration efficace du diagramme cumulé résultant.

3. Appareil selon la revendication 1, dans lequel l'émission comprend des particules bêta provenant de DNA, de RNA ou de protéine marqué radioactivement présent dans le gel d'électrophorèse.

4. Procédé d'obtention de données d'un gel d'électrophorèse contenant un échantillon de DNA, de RNA ou de protéine marqué radioactivement, comprenant les étapes suivantes :
la disposition du gel d'électrophorèse sur un écran de formation d'image revêtu d'un matériau de piégeage d'électrons pour la détection et l'accumulation d'énergie correspondant au flux et au diagramme d'émission du gel d'électrophorèse,
l'application au matériau de piégeage d'électrons d'énergie optique à une première longueur d'onde afin que e matériau de piégeage d'électrons libère de l'énergie optique à une seconde longueur d'onde correspondant au flux et au diagramme d'émission, et
la détection de l'énergie optique libérée à une seconde longueur d'onde et la conversion de cette énergie optique en signaux électriques représentatifs du flux et du diagramme d'émission,
caractérisé en ce que le matériau de piégeage d'électrons comprend
un matériau de base comprenant essentiellement du sulfure de strontium,
une première matière de dopage de samarium présente en quantité comprise entre 70 et 300 parties par million en poids, et
une seconde matière de dopage d'oxyde de cérium présente en quantité comprise entre 600 et 1 500 parties par million en poids.

5. Procédé selon la revendication 4, dans lequel la profondeur des pièges contenus dans le matériau de piégeage d'électrons est d'environ 1,0 eV.

6. Appareil destiné à l'obtention d'informations d'un gel d'électrophorèse contenant un échantillon de DNA, de RNA ou de protéine marqué radioactivement, comprenant
un dispositif de détection et de mémorisation d'informations correspondant à l'incidence d'un diagramme d'émission du gel d'électrophorèse, comprenant un écran de formation d'image revêtu d'un matériau de piégeage d'électrons destiné à accumuler temporairement les informations sous forme d'énergie correspondant au flux et au diagramme d'émission,
un dispositif d'application d'énergie optique à une première longueur d'onde au matériau de piégeage d'électrons de manière que ce matériau libère de l'énergie optique à une seconde longueur d'onde correspondant au flux et au diagramme d'émission, et
un dispositif de détection de l'énergie optique libérée à la seconde longueur d'onde et de transformation de l'énergie optique libérée en signaux électriques représentatifs du flux et du diagramme d'émission,
caractérisé en ce que le matériau de piégeage d'électrons comprend
un matériau de base choisi dans le groupe comprenant les sulfures de métaux alcalino-terreux,
une première matière de dopage de samarium,
une seconde matière de dopage choisie dans le groupe qui comprend l'oxyde de cérium, le fluorure de cérium, le chlorure de cérium et le sulfure de cérium, et
un halogénure de césium.

7. Appareil destiné à l'obtention d'informations d'un gel d'électrophorèse contenant un échantillon de DNA, de RNA ou de protéine marqué radioactivement, comprenant
un dispositif de détection et de mémorisation d'informations correspondant à l'incidence d'un diagramme d'émission du gel d'électrophorèse, comprenant un écran de formation d'image revêtu d'un matériau de piégeage d'électrons destiné à accumuler temporairement les informations sous forme d'énergie correspondant au flux et au diagramme d'émission,
un dispositif d'application d'énergie optique à une première longueur d'onde au matériau de piégeage d'électrons de manière que ce matériau libère de l'énergie optique à une seconde longueur d'onde correspondant au flux et au diagramme d'émission, et
un dispositif de détection de l'énergie optique libérée à la seconde longueur d'onde et de transformation de l'énergie optique libérée en signaux électriques représentatifs du flux et du diagramme d'émission,
caractérisé en ce que le matériau de piégeage d'électrons a une sensibilité infrarouge maximale comprise dans la plage de 1,12 ou 1,22 µm et émettant en réponse au rayonnement infrarouge un signal de sortie de lumière jaune-vert, et il comprend
un matériau de base contenant essentiellement du sulfure de calcium,
une première matière de dopage de samarium présente en quantité comprise entre 50 et 300 ppm en poids, et
une seconde matière de dopage choisie dans le groupe qui comprend l'oxyde de cérium, le fluorure de cérium, le chlorure de cérium et le sulfure de cérium présente en quantité comprise entre 200 et 1 500 parties par million en poids.

8. Procédé d'obtention de données d'un gel d'électrophorèse contenant un échantillon de DNA, de RNA ou de protéine marqué radioactivement, comprenant les étapes suivantes :
la disposition du gel d'électrophorèse sur un écran de formation d'image revêtu d'un matériau de piégeage d'électrons pour la détection et l'accumulation d'énergie correspondant au flux et au diagramme d'émission du gel d'électrophorèse,
l'application au matériau de piégeage d'électrons d'énergie optique à une première longueur d'onde afin que e matériau de piégeage d'électrons libère de l'énergie optique à une seconde longueur d'onde correspondant au flux et au diagramme d'émission, et
la détection de l'énergie optique libérée à une seconde longueur d'onde et la conversion de cette énergie optique en signaux électriques représentatifs du flux et du diagramme d'émission,
caractérisé en ce que le matériau de piégeage d'électrons comprend
un matériau de base choisi dans le groupe qui comprend les sulfures alcalino-terreux,
une première matière de dopage de samarium,
une seconde matière de dopage choisie dans le groupe qui comprend l'oxyde de cérium, le fluorure de cérium, le chlorure de cérium et le sulfure de cérium, et
un halogénure de césium.

9. Procédé d'obtention de données d'un gel d'électrophorèse contenant un échantillon de DNA, de RNA ou de protéine marqué radioactivement, comprenant les étapes suivantes :
la disposition du gel d'électrophorèse sur un écran de formation d'image revêtu d'un matériau de piégeage d'électrons pour la détection et l'accumulation d'énergie correspondant au flux et au diagramme d'émission du gel d'électrophorèse,
l'application au matériau de piégeage d'électrons d'énergie optique à une première longueur d'onde afin que e matériau de piégeage d'électrons libère de l'énergie optique à une seconde longueur d'onde correspondant au flux et au diagramme d'émission, et
la détection de l'énergie optique libérée à une seconde longueur d'onde et la conversion de cette énergie optique en signaux électriques représentatifs du flux et du diagramme d'émission,
caractérisé en ce que le matériau de piégeage d'électrons a une sensibilité infrarouge de crête dans la bande de 1,12 ou 1,22 µm et émettant, en réponse au rayonnement infrarouge, un signal de sortie de lumière jaune-vert, et il comprend
un matériau de base contenant essentiellement du sulfure de calcium,
une première matière de dopage de samarium présente en quantité comprise entre 50 et 300 parties par million en poids, et
une seconde matière de dopage choisie dans le groupe qui comprend l'oxyde de cérium, le fluorure de cérium, le chlorure de cérium et le sulfure de cérium, présente en quantité comprise entre 200 et 1 500 parties par million en poids.

10. Appareil d'obtention d'informations d'un gel d'électrophorèse contenant un échantillon de DNA, de RNA ou de protéine marqué par un colorant ou par chimiluminescence, comprenant
un dispositif de détection et de mémorisation d'informations correspondant à l'incidence d'un diagramme d'émission de lumière visible du gel d'électrophorèse, et comprenant un écran de formation d'image revêtu d'un matériau de piégeage d'électrons destiné à accumuler temporairement les informations sous forme d'énergie correspondant au flux et au diagramme d'émission de lumière visible,
un dispositif d'application d'énergie optique à une première longueur d'onde au matériau de piégeage d'électrons de manière que le matériau de piégeage d'électrons libère de l'énergie optique à une seconde longueur d'onde correspondant au flux et au diagramme d'émission de lumière visible, et
un dispositif de détection de l'énergie optique libérée à la seconde longueur d'onde et de transformation de l'énergie optique libérée en signaux électriques représentatifs du flux et du diagramme d'émission de lumière visible.

11. Appareil selon la revendication 10, dans lequel le matériau de piégeage d'électrons comporte un matériau de base d'un sulfure alcalino-terreux ou d'un mélange de sulfures alcalino-terreux dopé par du samarium métallique ou un composé du samarium, et dopé par un composé de l'europium.

12. Appareil selon la revendication 11, dans lequel le matériau de piégeage d'électrons contient en outre un sel fusible.

13. Appareil selon la revendication 1 ou 10, comprenant en outre un dispositif d'application d'énergie optique d'effacement ou dispositif de détection et d'accumulation d'énergie pour l'effacement des informations accumulées.

14. Ecran effaçable de formation d'image, destiné à être utilisé avec des gels d'électrophorèse contenant un échantillon de DNA, de RNA ou de protéine marqué par un colorant ou par chimiluminescence, comprenant
un substrat portant un matériau de piégeage d'électrons destiné à détecter et accumuler le diagramme d'émission de lumière visible du gel d'électrophorèse, le matériau de piégeage d'électrons pouvant libérer de l'énergie optique à une première longueur d'onde correspondant au diagramme accumulé d'émission de lumière visible, lorsqu'il est soumis à de l'énergie optique à une seconde longueur d'onde.

15. Procédé d'obtention de données d'un gel d'électrophorèse contenant un échantillon de DNA, de RNA ou de protéine marqué par un colorant ou par chimiluminescence, comprenant les étapes suivantes :
la disposition du gel d'électrophorèse sur un écran de formation d'image revêtu d'un matériau de piégeage d'électrons pour la détection et l'accumulation d'énergie correspondant au flux et au diagramme d'émission de lumière visible du gel d'électrophorèse,
l'application d'énergie optique à une première longueur d'onde au matériau de piégeage d'électrons afin que le matériau de piégeage d'électrons libère de l'énergie optique à une seconde longueur d'onde correspondant au flux et au diagramme d'émission de lumière visible, et
la détection d'énergie optique libérée à la seconde longueur d'onde et la transformation de l'énergie optique en signaux électriques représentatifs du flux et du diagramme d'émission de lumière visible.

16. Procédé selon la revendication 4 ou 15, comprenant en outre une étape d'application d'énergie optique d'effacement au matériau de piégeage d'électrons afin que le diagramme du rayonnement accumulé dans ce matériau soit effacé.
